# EUROPÄISCHE PATENTANMELDUNG

(11) **EP 4 262 047 A1**
(43) Veröffentlichungstag der Anmeldung: **18.10.2023**
(21) Anmeldenummer: 23166966.4
(22) Anmeldetag: 06.04.2023
(51) Int. Cl.: H02J 7/00

(54) **VERFAHREN UND SYSTEM ZUM BESTIMMEN MINDESTENS EINES NUTZUNGSPARAMETERS FÜR MINDESTENS EINEN AKKUPACK ZUM NUTZEN EINER LADEGERÄTEINRICHTUNG ZUM AUFLADEN VON BENUTZERAUSTAUSCHBAREN AKKUPACKS ZUM ANTRIEB MINDESTENS EINES MOBILEN GERÄTS**

(30) Priorität: 14.04.2022 DE 102022203773
(71) Anmelder: Andreas Stihl AG & Co. KG, 71336 Waiblingen (DE)
(72) Erfinder: Spindler, Christian, 70565 Stuttgart (DE); Moegle-Hofacker, Franzeska, 73525 Schwäbisch Gmünd (DE); Uhlmann, Christian, 91080 Uttenreuth (DE)
(74) Vertreter: Patentanwälte Ruff, Wilhelm, Beier, Dauster & Partner mbB

(57) **Zusammenfassung**

Die Erfindung bezieht sich auf ein Verfahren zum Bestimmen mindestens eines Nutzungsparameters (NP) für mindestens einen Akkupack (1) zum Nutzen einer Ladegeräteinrichtung (2) zum Aufladen von benutzeraustauschbaren Akkupacks (1) zum Antrieb mindestens eines mobilen Geräts (3), wobei ein Transportmittel (4) die Ladegeräteinrichtung (2) aufweist, wobei das Verfahren die Schritte aufweist:
a) Ermitteln von Zustands- und Nenngrößen (ZNG) der Akkupacks (1) betreffend ein mögliches Aufladen der Akkupacks (1) mittels der Ladegeräteinrichtung (2),
b) Ermitteln von möglichen Nutzungszeitdauern (NZD) der Akkupacks (1) zum möglichen Nutzen der Ladegeräteinrichtung (2) betreffend ein mögliches Aufladen der Akkupacks (1) mittels der Ladegeräteinrichtung (2), und
c) Bestimmen des mindestens einen Nutzungsparameters (NP) für mindestens einen der Akkupacks (1) zum Nutzen der Ladegeräteinrichtung (2) zum Aufladen des mindestens einen Akkupacks (1) mittels der Ladegeräteinrichtung (2) durch Verknüpfen der ermittelten Zustands- und Nenngrößen (ZNG) und der ermittelten möglichen Nutzungszeitdauern (NZD) unter Berücksichtigung mindestens einer Nutzungsgrenze (NR) der Ladegeräteinrichtung (2).

## Beschreibung

### ANWENDUNGSGEBIET UND STAND DER TECHNIK

Die Erfindung bezieht sich auf ein Verfahren und ein System, insbesondere jeweils, zum Bestimmen mindestens eines Nutzungsparameters für mindestens einen Akkupack zum Nutzen einer Ladegeräteinrichtung zum Aufladen von benutzeraustauschbaren Akkupacks zum Antrieb mindestens eines mobilen Geräts, wobei ein Transportmittel die Ladegeräteinrichtung aufweist.

### AUFGABE UND LÖSUNG

Der Erfindung liegt als Aufgabe die Bereitstellung eines Verfahrens und eines Systems, insbesondere jeweils, zum Bestimmen mindestens eines Nutzungsparameters für mindestens einen Akkupack zum Nutzen einer Ladegeräteinrichtung zum Aufladen von benutzeraustauschbaren Akkupacks zum Antrieb mindestens eines mobilen Geräts, wobei ein Transportmittel die Ladegeräteinrichtung aufweist, zugrunde, insbesondere wobei das Verfahren und das System, insbesondere jeweils, verbesserte Eigenschaften aufweisen.

Die Erfindung löst diese Aufgabe durch die Bereitstellung eines Verfahrens und eines Systems beschrieben in den unabhängigen Ansprüchen. Vorteilhafte Weiterbildungen und Ausgestaltungen der Erfindung sind in den abhängigen Ansprüchen beschrieben.

Das erfindungsgemäße Verfahren ist zum Bestimmen mindestens eines Nutzungsparameters für mindestens einen Akkupack zum Nutzen einer Ladegeräteinrichtung zum Aufladen von benutzeraustauschbaren Akkupacks, insbesondere jeweils, zum Antrieb mindestens eines mobilen Geräts ausgebildet. Ein Transportmittel weist die Ladegeräteinrichtung auf. Das Verfahren weist die Schritte auf: a) Ermitteln von, insbesondere jeweiligen und/oder tatsächlichen, Zustands- und Nenngrößen der Akkupacks betreffend ein, insbesondere jeweils, mögliches Aufladen der Akkupacks mittels der Ladegeräteinrichtung, b) Ermitteln von, insbesondere jeweiligen, möglichen Nutzungszeitdauern der Akkupacks zum möglichen Nutzen der Ladegeräteinrichtung betreffend ein mögliches, insbesondere das mögliche, Aufladen der Akkupacks mittels der Ladegeräteinrichtung, c) Bestimmen des, insbesondere tatsächlichen, mindestens einen Nutzungsparameters für mindestens einen der Akkupacks zum, insbesondere tatsächlichen, Nutzen der Ladegeräteinrichtung zum, insbesondere tatsächlichen, Aufladen des mindestens einen Akkupacks mittels der Ladegeräteinrichtung durch Verknüpfen der ermittelten Zustands- und Nenngrößen und der ermittelten möglichen Nutzungszeitdauern unter Berücksichtigung mindestens einer, insbesondere tatsächlichen, Nutzungsgrenze der Ladegeräteinrichtung.

Dies ermöglicht ein optimales Nutzen der Ladegeräteinrichtung und/oder, insbesondere somit, ein optimales Aufladen des mindestens einen Akkupacks, insbesondere während eines Transports mittels des Transportmittels und/oder in den Fällen, in denen mittels der Ladegeräteinrichtung aufgewiesen von dem Transportmittel in den möglichen Nutzungszeitdauern nicht alle Akkupacks, insbesondere voll, aufgeladen werden können.

Insbesondere können/kann das Verfahren, das Bestimmen, das Nutzen, das Aufladen, das Ermitteln und/oder das Verknüpfen automatisch sein. Zusätzlich oder alternativ kann das Aufladen drahtgebunden sein.

Das Bestimmen kann ein Bestimmen mindestens eines Werts des mindestens eines Nutzungsparameters sein. Zusätzlich oder alternativ kann das Bestimmen ein Bestimmen von Nutzungsparametern, insbesondere Werten der Nutzungsparameter und/oder für mehrere der Akkupacks, sein.

Der Nutzungsparameter kann einen Ladeparameter aufweisen, insbesondere sein.

Insbesondere in einem Fall bzw. bei einem Ausführen des Verfahrens, kann für Zustands- und Nenngrößen und mögliche Nutzungszeitdauern mindestens ein Nutzungsparameter bestimmt werden und, insbesondere in einem anderen Fall bzw. bei einem anderen bzw., insbesondere zeitlich, nächsten Ausführen des Verfahrens, kann für andere Zustands- und/oder Nenngrößen und/oder andere mögliche Nutzungszeitdauern mindestens ein anderer Nutzungsparameter bestimmt werden bzw. der mindestens eine Nutzungsparameter kann anders bestimmt werden bzw. sein, insbesondere variabel.

Der Begriff "Betreiben" kann für den Begriff "Nutzen" synonym verwendet werden.

Die Ladegeräteinrichtung kann elektrisch sein. Zusätzlich oder alternativ kann die Ladegeräteinrichtung in das Transportmittel, insbesondere fest, integriert sein.

Die Akkupacks, insbesondere ihre Zustands- und/oder Nenngrößen und/oder ihre möglichen Nutzungszeitdauern, können verschieden sein, insbesondere verschiedenen Typs.

Die Akkupacks können werkzeugfrei und/oder zerstörungsfrei benutzeraustauschbar sein.

Der Begriff "benutzerentnehmbar" kann für den Begriff "benutzeraustauschbar" synonym verwendet werden.

Der Begriff "Betrieb" kann für den Begriff "Antrieb" synonym verwendet werden.

Das mindestens eine Gerät kann von der Ladegeräteinrichtung verschieden sein. Zusätzlich oder alternativ kann das mindestens eine Gerät elektrisch angetrieben sein, insbesondere mittels mindestens eines der Akkupacks, und/oder ein Akkugerät sein. Weiter zusätzlich oder alternativ kann das mindestens eine Gerät zum Tragen mindestens eines der Akkupacks ausgebildet sein. Insbesondere kann das mindestens eine Gerät mindestens eine Akkupackaufnahme, insbesondere mindestens einen Akkupackschacht, aufweisen. Weiter zusätzlich oder alternativ kann das mindestens eine Gerät ein Elektromotorantriebssystem aufweisen, insbesondere das dazu ausgebildet sein kann, von mindestens einem der Akkupacks mit elektrischer Antriebsleistung versorgt zu werden. Weiter zusätzlich oder alternativ kann das mindestens eine Gerät ein Bearbeitungsgerät sein. Insbesondere kann das Bearbeitungsgerät ein Bearbeitungswerkzeug aufweisen. Zusätzlich kann das Elektromotorantriebssystem zum, insbesondere automatischen, Antrieb des Bearbeitungswerkzeugs ausgebildet sein. Weiter zusätzlich oder alternativ kann mobiles Gerät bedeuten, dass das Gerät, insbesondere inklusive mindestens eines der Akkupacks, eine Masse von maximal 50 kg (Kilogramm), insbesondere von maximal 20 kg, insbesondere von maximal 10 kg, insbesondere von maximal 5 kg, und/oder von minimal 0,5 kg, insbesondere von minimal 1 kg, insbesondere von minimal 2 kg, aufweisen kann.

Der Begriff "portabel" kann für den Begriff "mobil" synonym verwendet werden.

Der Begriff "konfiguriert" oder "vorgesehen" kann für den Begriff "ausgebildet" synonym verwendet werden.

Der Begriff "umfasst" oder "hat" kann für den Begriff "aufweist" synonym verwendet werden.

Das Ermitteln kann ein Ermitteln von Werten der Zustands- und Nenngrößen sein. Zusätzlich oder alternativ kann die mindestens eine Zustandsgröße, insbesondere jeweils, aktuell sein. Weiter zusätzlich oder alternativ kann oder braucht nicht die Nenngröße aktuell sein bzw. die Nenngröße kann sich typischerweise nicht ändern.

Der Begriff "erreichbar" oder "prognostiziert" kann für den Begriff "möglich" synonym verwendet werden.

Das Ermitteln kann ein Erfassen aufweisen, insbesondere sein.

Das Ermitteln kann ein Ermitteln von Werten der möglichen Nutzungszeitdauern sein. Zusätzlich oder alternativ kann oder braucht nicht das Ermitteln der möglichen Nutzungszeitdauern basierend auf den ermittelten Zustands- und/oder Nenngrößen sein.

Der Begriff "Belegungszeitdauer" kann für den Begriff "Nutzungszeitdauer" synonym verwendet werden.

Die Nutzungszeitdauer kann eine Ladezeitdauer aufweisen, insbesondere sein.

Das Aufladen kann von, insbesondere den, mehreren der Akkupacks sein.

Das Bestimmen kann unter Berücksichtigung mindestens eines Werts der mindestens einen Nutzungsgrenze sein. Zusätzlich oder alternativ kann das Bestimmen unter Berücksichtigung von Nutzungsgrenzen, insbesondere Werten der Nutzungsgrenzen, der Ladegeräteinrichtung sein.

Der Begriff "Limitierung" kann für den Begriff "Grenze" synonym verwendet werden.

Die Ladegeräteinrichtung kann die mindestens eine Nutzungsgrenze aufweisen bzw. begrenzt bzw. limitiert sein, insbesondere dadurch, dass das Transportmittel die Ladegeräteinrichtung aufweist.

Der Schritt b) kann zeitlich nach, mit und/oder vor dem Schritt a) ausgeführt werden. Zusätzlich oder alternativ kann der Schritt c) zeitlich nach dem Schritt a) und/oder dem Schritt b) ausgeführt werden. Weiter zusätzlich oder alternativ kann zeitlich nach dem Schritt c) der mindestens eine Akkupack die Ladegeräteinrichtung zum Aufladen des mindestens einen Akkupacks nutzen, insbesondere gemäß dem bestimmten mindestens einen Nutzungsparameter. Insbesondere kann das Verfahren den Schritt aufweisen: Nutzen, insbesondere automatisches Nutzen und/oder Aufladen, des mindestens einen Akkupacks mittels der Ladegeräteinrichtung, insbesondere gemäß dem bestimmten mindestens einen Nutzungsparameter. Weiter zusätzlich oder alternativ kann das Verfahren, insbesondere können/kann der Schritt a) und/oder der Schritt b) und/oder der Schritt c), zeitlich wiederholt ausgeführt werden, insbesondere mehrfach und/oder regelmäßig.

In einer Weiterbildung der Erfindung weist die mindestens eine Nenngröße auf, insbesondere ist, und/oder ist korrespondierend: ein maximaler, insbesondere maximal zulässiger, Auflade- und/oder Antriebsstrom, insbesondere von minimal 200 mA (Milliampere), insbesondere minimal 1 A (Ampere), und/oder maximal 1000 A, insbesondere maximal 200 A, und/oder eine maximale, insbesondere maximal zulässige, elektrische Auflade- und/oder Antriebsleistung, insbesondere von minimal 200 W (Watt), insbesondere minimal 1 kW (Kilowatt), und/oder maximal 10 kW, insbesondere maximal 5 kW, und/oder ein maximaler, insbesondere maximal zulässiger, elektrischer Energieinhalt, insbesondere von minimal 1 Wh (Wattstunde) und/oder maximal 8 kWh (Kilowattstunden), insbesondere 4 kWh, und/oder eine maximale, insbesondere maximal zulässige, Auflade- und/oder Antriebstemperatur, insbesondere 120 °C (Grad Celsius), und/oder eine minimale, insbesondere minimal zulässige, Auflade- und/oder Antriebstemperatur, insbesondere - 20 °C. Durch mindestens eine solche Größe kann das mögliche Nutzen, insbesondere das mögliche Aufladen, der Akkupacks mittels der Ladegeräteinrichtung begrenzt bzw. limitiert sein. Insbesondere kann die minimale Auflade- und/oder Antriebstemperatur unter der maximalen Auflade- und/oder Antriebstemperatur sein.

In einer Weiterbildung der Erfindung sind die, insbesondere jeweiligen, Akkupacks zum Antrieb mobiler Geräte. Zusätzlich oder alternativ ist das mindestens eine mobile Gerät boden- und/oder handgeführt, insbesondere handgetragen, und/oder ein Garten-, Forst-, Bau- und/oder Bodenbearbeitungsgerät, insbesondere eine Säge, oder ein Hoch-Entaster, oder eine Heckenschere, oder ein Heckenschneider, oder ein Gehölzschneider, oder eine Astschere, ein Trennschleifer, oder ein Blasgerät, oder ein Laubbläser, oder ein Sauggerät, oder ein Laubsauger, oder ein Reinigungsgerät, oder ein Hochdruckreiniger, oder ein Kehrgerät, oder eine Kehrwalze, oder eine Kehrbürste, oder ein Rasenmäher, oder eine Grasschere, oder ein Freischneider, oder ein Vertikutierer. Die möglichen Nutzungszeitdauern der Akkupacks, die zum Antrieb mindestens eines solchen Geräts ausgebildet sein können, zu dem möglichen Nutzen der Ladegeräteinrichtung können typischerweise begrenzt bzw. limitiert sein.

In einer Weiterbildung der Erfindung ist das Transportmittel ein Fahrzeug, insbesondere ein Landfahrzeug, insbesondere ein Straßenfahrzeug, insbesondere ein Kraftfahrzeug, insbesondere ein Automobil, oder ein Zweirad, insbesondere ein Motorrad, oder ein Anhänger. Durch ein solches Transportmittel kann die Ladegeräteinrichtung die mindestens eine Nutzungsgrenze aufweisen. Insbesondere kann das Straßenfahrzeug ein Lastenfahrrad sein. Zusätzlich oder alternativ kann der Anhänger ein Fahrzeuganhänger sein, insbesondere mit mechanischer und/oder elektrischer Verbindung zu einem Fahrzeug. Weiter zusätzlich oder alternativ kann das Fahrzeug autonom sein. Weiter zusätzlich oder alternativ kann ein Benutzer der Ladegeräteinrichtung, insbesondere ein Garten- und/oder Landschaftsbau-Betrieb, das Transportmittel betreiben. Zusätzlich oder alternativ kann das Transportmittel nicht von dem Benutzer des mindestens einen mobilen Geräts, sondern von einem Betreiber einer Flotte der mobilen Geräte, insbesondere Garten-, Forst-, Bau- und/oder Bodenbearbeitungsgeräte, betrieben werden, etwa einem Händler und/oder einem Verleiher.

In einer Weiterbildung der Erfindung weist die mindestens eine Nutzungsgrenze auf, insbesondere ist, und/oder ist korrespondierend: ein, insbesondere variabler, maximaler Gesamtaufladestrom und/oder eine, insbesondere variable, maximale elektrische Gesamtaufladeleistung zum Aufladen des mindestens einen Akkupacks, und/oder eine, insbesondere variable, maximale Kühlleistung zum Kühlen des mindestens einen Akkupacks, insbesondere zeitlich vor und/oder mit dem Aufladen, und/oder eine, insbesondere variable, maximale Heizleistung zum Heizen des mindestens einen Akkupacks, insbesondere zeitlich vor dem Aufladen, und/oder eine maximale Anzahl, insbesondere Mehrzahl, von Leistungsabgabeschnittstellen, insbesondere Akkupackaufnahmen, insbesondere Akkupackschächten, insbesondere für den mindestens einen Akkupack. Das Verfahren ermöglicht das optimale Nutzen der Ladegeräteinrichtung und/oder das optimale Aufladen des mindestens einen Akkupacks in den Fällen, in denen mittels der Ladegeräteinrichtung in den möglichen Nutzungszeitdauern nicht allen Akkupacks ausreichend Aufladestrom und/oder Aufladeleistung und/oder Kühlleistung und/oder Heizleistung und/oder eine Leistungsabgabeschnittstelle zur Verfügung gestellt werden kann. Insbesondere können/kann der Gesamtaufladestrom, die Gesamtaufladeleistung, die Kühlleistung und/oder die Heizleistung begrenzt bzw. limitiert sein dadurch, dass die Ladegeräteinrichtung nicht zeitlich dauerhaft von dem Transportmittel extern mit elektrischer Leistung versorgt sein kann, insbesondere während eines Transports mittels des Transportmittels. Zusätzlich oder alternativ kann eine Summe der Gesamtaufladeleistung, der Kühlleistung und/oder der Heizleistung begrenzt sein. Weiter zusätzlich oder alternativ kann das Verfahren den Schritt aufweisen: Ermitteln der mindestens einen, insbesondere aktuellen, Nutzungsgrenze, insbesondere des Gesamtaufladestroms, der Gesamtaufladeleistung, der Kühlleistung und/oder der Heizleistung, und das Bestimmen kann unter Berücksichtigung der ermittelten mindestens einen Nutzungsgrenze sein. Weiter zusätzlich oder alternativ kann die Ladegeräteinrichtung mindestens einen, insbesondere elektrischen, Kühler, insbesondere ein Peltier-Element und/oder einen Ventilator bzw. einen Lüfter, zu dem Kühlen und/oder mindestens einen, insbesondere elektrischen, Heizer, insbesondere einen Radiator, zu dem Heizen aufweisen. Weiter zusätzlich oder alternativ kann die Leistungsabgabeschnittstelle eine mechanische Schnittstelle und eine elektrische Schnittstelle vereinen. Weiter zusätzlich oder alternativ kann der Begriff "Akkupackladeschnittstelle" für den Begriff "Leistungsabgabeschnittstelle" synonym verwendet werden. Weiter zusätzlich oder alternativ kann die Ladegeräteinrichtung eine Art und eine Anzahl von Ladegeräten (Einzellader, Mehrfachlader) aufweisen, wobei aus der Art und der Anzahl von Ladegeräten die Anzahl von Leistungsabgabeschnittstellen, insbesondere Akkupackaufnahmen, bestimmt werden kann. Weiter zusätzlich oder alternativ kann die mindestens eine Nutzungsgrenze, insbesondere die Gesamtaufladeleistung, mit einer Aufladeleistung der im Transportmittel verfügbaren Akkupacks und/oder einer Abgabeleistung der belegten Leistungsabgabeschnittstellen, insbesondere Akkupackaufnahmen, und/oder der an einem Einsatzort benötigten Akkupacks korrespondieren. Dies kann ermöglichen, dass die mit belegten Leistungsabgabeschnittstellen, insbesondere Akkupackaufnahmen, verbundenen Akkupacks während des Transports, insbesondere einer Fahrt, zu einem nächsten Einsatzort aufgeladen werden können. Weiter zusätzlich oder alternativ kann bei optional bevorzugt vorgesehenen Schnellladevorgängen mehr Kühlleistung typischerweise erforderlich sein als bei Ladevorgängen, die unabhängig von einem Transport, insbesondere einer Fahrt, des Transportmittels sein können. Insbesondere kann als Referenz dabei ein Aufladevorgang bei Stillstand des Transportmittels dienen, wobei vorgesehen sein kann, dass insbesondere in Pausenzeiten oder über Nacht ein Anschluss, insbesondere ein Elektrizitätsanschluss, des Transportmittels an ein externes öffentliches oder privates Stromnetz erfolgen kann.

In einer Weiterbildung der Erfindung weist das Transportmittel mindestens eine, insbesondere direkte, Strahlungsenergie-Umwandlungs-Einrichtung, insbesondere eine Solarzelle, und/oder mindestens eine Brennstoffzelle und/oder mindestens einen, insbesondere elektrischen, Energiespeicher, insbesondere eine Batterie, zur Versorgung der Ladegeräteinrichtung mit elektrischer Leistung auf. Dies ermöglicht das Nutzen, insbesondere das Aufladen, während eines Transports mittels des Transportmittels und/oder, dass die mindestens eine Nutzungsgrenze variabel sein kann. Insbesondere kann die mindestens eine Strahlungsenergie-Umwandlungs-Einrichtung elektrisch und/oder eine Solarenergie-Umwandlungs-Einrichtung sein. Zusätzlich oder alternativ können/kann die mindestens eine Strahlungsenergie-Umwandlungs-Einrichtung, die mindestens eine Brennstoffzelle und/oder der mindestens eine Energiespeicher in das Transportmittel, insbesondere fest, integriert sein. Weiter zusätzlich oder alternativ kann der mindestens eine Energiespeicher, insbesondere werkzeugbehaftet und/oder zerstörungsfrei, austauschbar bzw. entnehmbar und/oder nachgerüstet und/oder ein Transportmittelakku, insbesondere ein Fahrzeugakku, sein. Weiter zusätzlich oder alternativ kann der mindestens eine Energiespeicher aufladbar sein, insbesondere mit elektrischer Leistung von der mindestens einen Strahlungsenergie-Umwandlungs-Einrichtung und/oder der mindestens einen Brennstoffzelle. Weiter zusätzlich oder alternativ kann der mindestens eine Energiespeicher ein Zwischenspeicher sein. Weiter zusätzlich oder alternativ kann der mindestens eine Energiespeicher mit einer Betriebsleistung von größer als 1,5 kWh sein. Weiter zusätzlich oder alternativ kann der mindestens eine Energiespeicher von den Akkupacks verschieden sein. Weiter zusätzlich oder alternativ kann die Versorgung automatisch sein.

In einer Weiterbildung der Erfindung weist die mindestens eine Zustandsgröße auf, insbesondere ist, und/oder ist korrespondierend: ein Ladezustand (SoC), und/oder eine Temperatur. Durch mindestens eine solche Größe kann das mögliche Nutzen, insbesondere das mögliche Aufladen, der Akkupacks mittels der Ladegeräteinrichtung begrenzt bzw. limitiert sein. Insbesondere kann der Begriff "Restenergie" oder "Energieinhalt" für den Begriff "Ladezustand" synonym verwendet werden.

Zusätzlich oder alternativ kann vorgesehen sein, eine Temperatur der Umgebung der Akkupacks zu erfassen.

In einer Ausgestaltung der Erfindung weist der Schritt c) auf: Bestimmen von, insbesondere jeweiligen, Kühlzeitdauern zum, insbesondere zu dem, Kühlen und/oder, insbesondere jeweiligen, Heizzeitdauern zum, insbesondere zu dem, Heizen der Akkupacks basierend auf der mindestens einen ermittelten maximalen Aufladetemperatur und/oder der mindestens einen ermittelten minimalen Aufladetemperatur sowie der ermittelten Temperaturen, insbesondere unter Berücksichtigung der maximalen Kühlleistung und/oder der maximalen Heizleistung, insbesondere soweit erforderlich. Bestimmen von, insbesondere jeweiligen, möglichen Aufladezeitdauern zum, insbesondere zu dem, Aufladen der Akkupacks basierend auf den bestimmten Kühlzeitdauern, soweit erforderlich, und/oder den bestimmten Heizzeitdauern, soweit erforderlich, sowie den ermittelten möglichen Nutzungszeitdauern. Bestimmen von, insbesondere jeweiligen, möglichen elektrischen Aufladeenergiemengen der Akkupacks basierend auf den bestimmten möglichen Aufladezeitdauern sowie dem mindestens einen ermittelten maximalen Aufladestrom und/oder der mindestens einen ermittelten maximalen Aufladeleistung, insbesondere und dem mindestens einen ermittelten maximalen elektrischen Energieinhalt und/oder den ermittelten Ladezuständen und/oder unter Berücksichtigung des maximalen Gesamtaufladestroms und/oder der maximalen elektrischen Gesamtaufladeleistung. Bestimmen des mindestens einen Nutzungsparameters basierend auf den bestimmten möglichen Aufladeenergiemengen, insbesondere beginnend mit der größten Aufladeenergiemenge und/oder unter Berücksichtigung der maximalen Anzahl von Leistungsabgabeschnittstellen. Dies ermöglicht ein besonders optimales Nutzen der Ladegeräteinrichtung und/oder ein besonders optimales Aufladen des mindestens einen Akkupacks. Insbesondere kann das Bestimmen automatisch sein. Zusätzlich oder alternativ kann das Bestimmen ein Bestimmen von Werten der Kühlzeitdauern, Werten der Heizzeitdauern, Werten der Aufladezeitdauern und/oder Werten der Aufladeenergiemengen sein. Weiter zusätzlich oder alternativ kann eine Information, ob eine Leistungsabgabeschnittstelle, insbesondere eine Akkupackaufnahme, belegt oder nicht belegt ist, durch die Akkupacks ermittelt und übertragen werden. Weiter zusätzlich oder alternativ kann die Information durch die Ladegeräteinrichtung, insbesondere durch die Ladegeräte und/oder ein Gateway, ermittelt und übertragen werden. Weiter zusätzlich oder alternativ kann, insbesondere vorteilhaft, der Energiespeicher zu der Versorgung der Ladegeräteinrichtung so bzw. derart ausgelegt sein, dass die Gesamtaufladeleistung bei Belegung aller im Transportmittel vorgesehenen Leistungsabgabeschnittstellen, insbesondere Akkupackaufnahmen, die Betriebsleistung des Energiespeichers nicht überschreiten kann. Weiter zusätzlich oder alternativ kann der mindestens eine Nutzungsparameter derart bestimmt werden, dass ein Aufladezustand und eine Aufladezeitdauer bestimmt werden, wobei der Aufladezustand sich auf einen Zeitpunkt nach Ablauf der Nutzungszeitdauer der Ladegeräteinrichtung beziehen kann. Somit kann das Bestimmen des mindestens einen Nutzungsparameters eine Aufladezustandsprognose aufweisen. Weiter zusätzlich oder alternativ kann die Aufladezeitdauer t bestimmt werden als: t = f(AkkuTyp, LaderTyp, SoC, SoH(%), Kühlzeitdauer+Delta_SoC, Heizzeitdauer+Delta_SoC, Faktor_Lademodus(%)), mit SoH für "State of Health". Weiter zusätzlich oder alternativ kann die Aufladezeitdauer t, insbesondere bevorzugt, basierend auf bzw. unter Berücksichtigung einer, insbesondere der und/oder ermittelten maximalen, elektrischen Aufladeleistung zum Aufladen des mindestens einen Akkupacks und einer, insbesondere maximalen, elektrischen Aufladeleistung eines Ladegerät-Typs des zum Aufladen vorgesehenen Ladegeräts bestimmt werden: t = f(Aufladeleistung_Akku, Aufladeleistung_Lader, SoC, SoH(%), Kühlzeitdauer+Delta_SoC, Heizzeitdauer+Delta_SoC, Faktor_Lademodus(%)). Weiter zusätzlich oder alternativ kann die Kühlzeitdauer des Akkupacks von einer Temperaturdifferenz zwischen der Temperatur des Akkupacks und der Temperatur der Umgebung abhängen. Weiter zusätzlich oder alternativ kann die Kühlzeitdauer von dem verfügbaren Ladegerät-Typ abhängen, somit von der Akkupack-Ladegerät-Kombination. Beispielsweise können verschiedene Ladegeräte verschiedene Lüfter-Typen aufweisen. Weiter zusätzlich oder alternativ kann die Heizzeitdauer von der Temperatur des Akkupacks und einer Stromstärke abhängen. Weiter zusätzlich oder alternativ kann ein Heizen nur bis zum Beginn des Aufladens vorgesehen sein. Insbesondere kann während das Aufladens eine Nutzung der Verlustleistung des Ladegeräteinrichtung, die in thermische Energie umgesetzt werden kann, vorgesehen sein. Dies kann ermöglichen, die Aufladeleistung abhängig von der Kühl- oder Heizleistung zu bestimmen. Insbesondere kann vermieden werden, dass aufgrund einer Kühl- oder Heizleistung keine Aufladeleistung mehr zur Verfügung stehen kann. Weiter zusätzlich oder alternativ kann die Kühl- oder Heizleistung zur Vorkonditionierung des Akkupacks vor einem Einsatz des Akkupacks aufgewendet werden.

In einer Weiterbildung der Erfindung weist der Schritt c) auf: Bestimmen des mindestens einen Nutzungsparameters anhand, insbesondere nur, eines, insbesondere einzigen, Optimierungskriteriums. Das Optimierungskriterium ist eine, insbesondere die, größte Aufladeenergiemenge, insbesondere ein größter Wert der Aufladeenergiemenge, des mindestens einen Akkupacks. Dies ermöglicht ein besonders optimales Nutzen der Ladegeräteinrichtung und/oder ein besonders optimales Aufladen des mindestens einen Akkupacks. Mit anderen Worten: Bestimmen des mindestens einen Nutzungsparameters so, dass möglichst viel Energie, insbesondere in Summe, in die in dem Transportmittel verfügbaren Akkupacks geladen werden kann. Insbesondere kann das Optimierungsproblem gelöst werden durch Bestimmen von 1 - (P(T_Akku, AL in %) * SoC(Akku)) so, dass ein Wert erhalten wird, der gegen 1 geht. P(T_Akku, AL in %) gibt die Aufladeleistung für eine Akkupack-Ladegerät-Kombination an. Insbesondere können basierend darauf Ladevorgänge für Leistungsabgabeschnittstellen, insbesondere Akkupackaufnahmen, einzelner Ladegeräte gestartet bzw. gestoppt werden. Insbesondere kann das Starten bzw. das Stoppen einem Zuschalten bzw. einem Abschalten der Leistungsabgabeschnittstellen, insbesondere der Akkupackaufnahmen, entsprechen, insbesondere gleichen. Zusätzlich oder alternativ kann das Starten bzw. das Stoppen von einer Kontrolle, insbesondere einer Steuerung und/oder einer Regelung, des Ladevorgangs verschieden sein.

In einer Weiterbildung, insbesondere einer Ausgestaltung, der Erfindung weist der mindestens eine Nutzungsparameter auf, insbesondere ist, und/oder ist korrespondierend: den mindestens einen Akkupack, insbesondere mindestens eine Kennzeichnung des mindestens einen Akkupacks, zum Nutzen der Ladegeräteinrichtung, und/oder mindestens eine Kühlleistung zum, insbesondere zu dem, Kühlen und/oder mindestens eine Heizleistung zum, insbesondere zu dem, Heizen des mindestens einen Akkupacks, und/oder mindestens einen Aufladestrom und/oder mindestens eine elektrische Aufladeleistung zum, insbesondere zu dem, Aufladen des mindestens einen Akkupacks. Insbesondere kann der mindestens eine Nutzungsparameter, insbesondere aufweisend die elektrische Aufladeleistung, derart bestimmt werden, dass die Aufladeleistung für den mindestens einen Akkupack der Gesamtaufladeleistung korrespondieren bzw. entsprechen, insbesondere gleichen, kann.

Zusätzlich oder alternativ kann der mindestens eine Nutzungsparameter derart bestimmt werden, dass eine Auslastung der Akkupacks mit einem gleichmäßigen Verschleiß verbunden sein kann. Insbesondere kann vorgesehen sein, dass die Kühlleistung und/oder die Heizleistung und/oder der Aufladestrom so angepasst werden, dass sich eine effiziente, gleichmäßige Nutzung der Akkupacks ergeben kann. Insbesondere kann die Kühlleistung und/oder die Heizleistung durch eine Vorrichtung zur Klimatisierung des Transportmittels und/oder durch die Ladegeräteinrichtung, insbesondere die Ladegeräte, aufgebracht werden.

In einer Weiterbildung der Erfindung weist das Verfahren den Schritt auf: d) Ausgeben einer benutzerwahrnehmbaren Information über den mindestens einen bestimmten Nutzungsparameter, insbesondere den mindestens einen Akkupack zum Nutzen der Ladegeräteinrichtung. Dies ermöglicht einem Benutzer wahrzunehmen, welchen der Akkupacks er Austauschen kann. Insbesondere kann das Ausgeben automatisch, optisch, akustisch und/oder haptisch und/oder ein Ausgeben eines Inhalts der Information und/oder des Nutzungsparameters sein. Insbesondere kann das optische Ausgeben ein Anzeigen aufweisen. Zusätzlich oder alternativ kann das haptische Ausgeben ein Vibrieren aufweisen. Weiter zusätzlich oder alternativ können an dem Einsatzort nicht mehr benötigte Akkupacks und/oder für das Aufladen bestimmte bzw. ausgewählte Akkupacks ausgeben bzw. signalisieren, z.B. optisch oder akustisch, dass sie zum Aufnehmen in das Transportmittel und zum Verbinden mit der Leistungsabgabeschnittstelle, insbesondere zum Einsetzen in die Akkupackaufnahme, vorgesehen sein können. Weiter zusätzlich oder alternativ, insbesondere analog, können die dem Transportmittel zu entnehmenden, an dem Einsatzort benötigten, Akkupacks ausgeben bzw. signalisieren, dass sie dem Transportmittel entnommen werden können. Weiter zusätzlich oder alternativ kann vorgesehen sein, dass die benutzerwahrnehmbare Information an eine Benutzer-Schnittstelle übertragen bzw. übermittelt und ausgegeben werden kann.

In einer Weiterbildung der Erfindung weist der Schritt a) auf: drahtloses Übertragen der mindestens einen Zustandsgröße, insbesondere von mindestens einem der Akkupacks, insbesondere nicht nutzend die Ladegeräteinrichtung. Somit kann das Ermitteln einfach sein. Insbesondere kann der Begriff "kabellos" für den Begriff "drahtlos" synonym verwendet werden. Zusätzlich oder alternativ kann das Übertragen automatisch und/oder ein Übertragen mindestens eines Werts der mindestens einen Zustandsgröße und/oder mittels eines Gateways sein. Insbesondere kann das Gateway mit einer Positionsbestimmungsvorrichtung und/oder installiert in dem Transportmittel und/oder an Einsatz- und/oder Lagerorten sein. Weiter zusätzlich oder alternativ können/kann remote von dem Transportmittel sein: Datenbanken, Server, Clouds (z.B. Backend, Routenplaner, Verkehrsinformation), Cloud-to-Cloud-Schnittstellen und Cloud-to-Cloud-Kommunikation. Beispielsweise kann vorgesehen sein, dass ein digitaler Zwilling des Transportmittels und der Einsatzorte entfernt (remote) vom Transportmittel bereitgehalten werden kann. Insbesondere kann der digitale Zwilling als ein Modell für das Nutzen bzw. das Betreiben der Ladegeräteinrichtung ausgebildet sein. Insbesondere kann das Modell mindestens aufweisen bzw. umfassen: eine durchschnittliche Leistung P (Wh/Zeit), die eine durchschnittliche Aufladeleistung bzw. eine durchschnittliche Energiezufuhr (Betrag Wh/Zeit positiv) oder eine durchschnittliche Antriebs- bzw. Entladeladeleistung bzw. ein durchschnittlicher Energieverbrauch (Betrag Wh/Zeit negativ) sein kann, des jeweiligen Akkupacks, und/oder eine Geoposition, einen Akkupack-Bezeichner (z.B. einen Akkupack-Typ) und/oder eine eindeutige Kennzeichnung bzw. Kennung (z.B. eine ID) des jeweiligen Akkupacks, und/oder den SoH, die Temperatur (T), den Ladezustand (SoC) des jeweiligen Akkupacks, und/oder eine Anzahl der verfügbaren Akkupacks in dem Transportmittel. Weiter zusätzlich oder alternativ kann das Modell die Art und die Anzahl der Ladegeräte, eine Anzahl in das Transportmittel aufnehmbarer Akkupacks, die insbesondere einer Anzahl nicht belegter Leistungsabgabeschnittstellen, insbesondere Akkupackaufnahmen, entsprechen, insbesondere gleichen, kann, und/oder eine Temperatur der Umgebung aufweisen bzw. umfassen.

In einer Weiterbildung der Erfindung weist mindestens eine der möglichen Nutzungszeitdauern auf, insbesondere ist, und/oder ist korrespondierend: eine mögliche Aufenthaltszeitdauer mindestens eines der Akkupacks an Bord des Transportmittels, insbesondere eine mögliche Transportzeitdauer des Transportmittels, insbesondere von einem Ausgangsort bzw. Abfahrtsort bzw. Startort, zu einem möglichen Antriebsort bzw. Ankunftsort bzw. Zielort bzw. Einsatzort mindestens eines der Akkupacks. Durch eine solche Nutzungszeitdauer kann das Nutzen der Ladegeräteinrichtung zu dem Aufladen des mindestens einen Akkupacks sein, wenn der mindestens eine Akkupack sowieso nicht eingesetzt werden kann. Insbesondere kann das Transportmittel zur Versorgung räumlich verschieden gelegener Einsatzorte mit Akkupacks vorgesehen sein. Insbesondere können die Einsatzorte von einem Benutzer der mobilen Geräte, insbesondere einem Flottenmanager und/oder einem Fahrer, und/oder einem Betreiber des Transportmittels mittels einer Benutzer-Schnittstelle erfasst werden. Zusätzlich oder alternativ kann an den Einsatzorten mindestens ein Benutzer der mobilen Geräte oder eine Gruppe von Benutzern der mobilen Geräte, insbesondere ein Team, arbeiten mit jeweils mindestens einem mobilen Gerät, das von mindestens einem der Akkupacks versorgt werden kann. Weiter zusätzlich oder alternativ kann vorgesehen sein, die Anzahl der Benutzer an den Einsatzorten und den Bedarf an mobilen Geräten an den Einsatzorten zur Ausführung von Arbeitsaufgaben mittels der Benutzer-Schnittstelle zu erfassen. Insbesondere kann die Geoposition der Akkupacks in diesem Fall dem Einsatzort entsprechen, insbesondere gleichen. Weiter zusätzlich oder alternativ kann für den Benutzer oder die Gruppe basierend auf auszuführenden Arbeitsaufgaben und basierend auf den dazu vorgesehenen mobilen Geräten ein Energiebedarf an dem Einsatzort bestimmt werden. Insbesondere kann der Energiebedarf wiederholt neu bestimmt werden. Zusätzlich oder alternativ kann basierend auf der Bestimmung der Energiebedarf, der einer Anzahl von Akkupacks verschiedenen Typs entsprechen, insbesondere gleichen, kann, an ein Gateway und/oder einen Server, der eine Datenbank bereitstellen kann, und/oder ein Modell übertragen bzw. übermittelt werden. Weiter zusätzlich oder alternativ können abhängig von einem Arbeitsfortschritt sich die Ladezustände der Akkupacks an dem Einsatzort ändern. Insbesondere kann für die Akkupacks wiederholt und/oder regelmäßig ermittelt werden, welcher Akkupack aufgeladen werden soll. Insbesondere kann ein aufzuladender Akkupack einem an dem Einsatzort nicht benötigten (bzw. nicht mehr benötigten) Akkupack entsprechen, insbesondere gleichen, der von dem Transportmittel aufgenommen werden kann. Insbesondere kann die Art und die Anzahl nicht mehr benötigter Akkupacks an das Gateway und/oder die Datenbank und/oder das Modell übertragen bzw. übermittelt werden. Insbesondere kann das Transportmittel das Gateway aufweisen. Zusätzlich oder alternativ kann das Übertragen bzw. das Übermitteln ermöglichen, dass die Schritte b) und c) besonders gut ausgeführt werden können. Weiter zusätzlich oder alternativ kann die Position des Transportmittels regelmäßig bestimmt und aktualisiert werden. Insbesondere kann für den jeweils nächsten Einsatzort basierend auf der aktuellen Position des Transportmittels eine Transportstecke, insbesondere eine Fahrtstrecke, und eine Transportzeitdauer, insbesondere eine Fahrtzeitdauer, bestimmt werden. Insbesondere kann die Bestimmung einer Fahrtstrecke und einer Fahrtdauer mittels gängiger Verfahren zur Routenplanung unter Berücksichtigung von Verkehrsinformationen ausgeführt werden. Beispielsweise werden dabei Cloud-to-Cloud-Schnittstellen genutzt. Zusätzlich oder alternativ kann die Fahrtstrecke eine Fahrtstrecke von einem Ort A zu einem Ort B sein. Zusätzlich oder alternativ kann vorgesehen sein, dass die Fahrtstrecke eine Fahrtstrecke von einem Ausgangsort, insbesondere einem Lagerort der Akkupacks und/oder einer Werkstatt, zu einem Einsatzort sein kann und umgekehrt und/oder eine Fahrtstrecke von einem beliebigen Einsatzort N zu einem weiteren Einsatzort M. Weiter zusätzlich oder alternativ kann basierend auf der Fahrtstrecke und der Fahrtzeitdauer eine voraussichtliche Ankunftszeit für den jeweils nächsten Einsatzort bestimmt und übertragen bzw. übermittelt werden. Insbesondere kann die voraussichtliche Ankunftszeit und die dem Energiebedarf entsprechende Anzahl Akkupacks an ein Gateway und/oder den Benutzer, insbesondere einen Vorarbeiter, und/oder die Gruppe am jeweiligen Einsatzort übertragen bzw. übermittelt werden. Zusätzlich oder alternativ kann die voraussichtliche Ankunftszeit und die dem Energiebedarf entsprechende Anzahl Akkupacks in einer Datenbank hinterlegt und für weitere Benutzer der Ladegeräteinrichtung, insbesondere einen Flottenmanager, abrufbar sein. Weiter zusätzlich oder alternativ kann vorgesehen sein, dass vollaufgeladene und aufladende Akkupacks in dem Transportmittel, insbesondere dem Fahrzeug, sein können. Weiter zusätzlich oder alternativ kann die Aufladezustandsprognose den Aufladezustand angeben, der der voraussichtlichen Ankunftszeit an dem jeweils nächsten Einsatzort entsprechen, insbesondere gleichen, kann (Beispiel Prognose: "Am Zielort werden Dir 2 kWh Energie in 7 Akkupacks mit < 80% SoC zur Verfügung stehen"). Insbesondere kann die Aufladezustandsprognose eine Abschätzung ermöglichen, ob der Energiebedarf an dem jeweils nächsten Einsatzort erfüllt werden kann. Weiter zusätzlich oder alternativ kann vorgesehen sein, dass für das Ermitteln der Nutzungszeitdauern Einsatzorte bestimmt werden basierend auf einer Menge vorgegebener Einsatzorte, denen jeweilige auszuführende Arbeitsaufgaben zugeordnet sein können. Insbesondere basierend auf den auszuführenden Arbeitsaufgaben kann der Energiebedarf an dem jeweiligen möglichen Einsatzort bestimmt werden. Insbesondere basierend auf dem Energiebedarf kann der mindestens eine Nutzungsparameter bestimmt werden gemäß Schritt c), zumindest eine maximale Aufladezeitdauer (z.B. in Form einer Aufladedauerprognose) für die dem Energiebedarf entsprechende Anzahl von Akkupacks. Insbesondere kann die Anzahl von Akkupacks in dem Transportmittel verfügbar sein. Zusätzlich oder alternativ kann für jeden Einsatzort aus der Menge vorgegebener Einsatzorte basierend auf der aktuellen Position des Transportmittels eine Fahrtstrecke und eine Fahrtzeitdauer bestimmt werden. Insbesondere kann durch einen Abgleich der maximalen Aufladezeitdauer mit der Fahrtzeitdauer aus der Menge vorgegebener Einsatzorte ein Einsatzort ermittelt werden. Insbesondere kann dementsprechend die Bestimmung des Einsatzorts beinhalten, dass zur voraussichtlichen Ankunftszeit die Akkupacks so aufgeladen sind, dass der Energiebedarf an dem Einsatzort erfüllt werden kann. Zusätzlich oder alternativ kann die Aufladezustandsprognose auf der Fahrtzeitdauer basieren, die den Nutzungszeitdauern entsprechen, insbesondere gleichen, kann. Mit anderen Worten: Optimierungsproblem "Bestimmen des nächsten Orts".

Das erfindungsgemäße System ist zum, insbesondere zu dem, Bestimmen mindestens eines, insbesondere des mindestens einen, Nutzungsparameters für, insbesondere den, mindestens einen Akkupack zum, insbesondere zu dem, Nutzen einer, insbesondere der, Ladegeräteinrichtung zum, insbesondere zu dem, Aufladen von, insbesondere den, benutzeraustauschbaren Akkupacks zum Antrieb mindestens eines, insbesondere des mindestens einen, mobilen Geräts ausgebildet. Ein, insbesondere das, Transportmittel weist die Ladegeräteinrichtung auf. Das System weist auf: eine Ermittlungseinrichtung und eine Bestimmungseinrichtung. Die Ermittlungseinrichtung ist ausgebildet: zum, insbesondere zu dem, Ermitteln von, insbesondere den, Zustands- und Nenngrößen der Akkupacks betreffend ein mögliches, insbesondere das mögliche, Aufladen der Akkupacks mittels der Ladegeräteinrichtung, und zum, insbesondere zu dem, Ermitteln von, insbesondere den, möglichen Nutzungszeitdauern der Akkupacks zum, insbesondere zu dem, möglichen Nutzen der Ladegeräteinrichtung betreffend ein mögliches, insbesondere das mögliche, Aufladen der Akkupacks mittels der Ladegeräteinrichtung. Die Bestimmungseinrichtung ist ausgebildet: zum, insbesondere zu dem, Bestimmen des mindestens einen Nutzungsparameters für, insbesondere den, mindestens einen der Akkupacks zum, insbesondere zu dem, Nutzen der Ladegeräteinrichtung zum, insbesondere zu dem, Aufladen des mindestens einen Akkupacks mittels der Ladegeräteinrichtung durch, insbesondere das, Verknüpfen der ermittelten Zustands- und Nenngrößen und der ermittelten möglichen Nutzungszeitdauern unter Berücksichtigung mindestens einer, insbesondere der mindestens einen, Nutzungsgrenze der Ladegeräteinrichtung. Insbesondere kann das System zum, insbesondere automatischen, Ausführen eines, insbesondere des, Verfahrens wie vorhergehend genannt ausgebildet sein. Zusätzlich oder alternativ können/kann das System, die Ermittlungseinrichtung und/oder die Bestimmungseinrichtung elektrisch sein.

In einer Weiterbildung der Erfindung weist das System auf: die Akkupacks, die Ladegeräteinrichtung, das mindestens eine mobile Gerät und/oder das Transportmittel.

### KURZBESCHREIBUNG DER ZEICHNUNGEN

Weitere Vorteile und Aspekte der Erfindung ergeben sich aus den Ansprüchen und aus der Beschreibung von Ausführungsbeispielen der Erfindung, die nachfolgend anhand der Figuren erläutert sind. Dabei zeigen:
- Fig. 1: schematisch ein erfindungsgemäßes Verfahren und ein erfindungsgemäßes System zum Bestimmen mindestens eines Nutzungsparameters für mindestens einen Akkupack zum Nutzen einer Ladegeräteinrichtung zum Aufladen von benutzeraustauschbaren Akkupacks zum Antrieb mindestens eines mobilen Geräts, wobei ein Transportmittel die Ladegeräteinrichtung aufweist,
- Fig. 2: schematisch Details in Form von Schritten des Verfahrens der Fig. 1 ausgeführt mittels des Systems der Fig. 1,
- Fig. 3: schematisch Details in Form von Einrichtungen des Systems der Fig. 1,
- Fig. 4: schematisch weitere Details in Form von Einrichtungen des Systems der Fig. 1,
- Fig. 5: schematisch das Verfahren der Fig. 1 aufweisend eine Aufladedauerprognose basierend auf einem Energiebedarf für einen Arbeitseinsatz, und
- Fig. 6: schematisch das Verfahren der Fig. 1 aufweisend ein Bestimmen von Kühlzeitdauern zum Kühlen, Heizzeitdauern zum Heizen und möglichen Aufladezeitdauern zum Aufladen der Akkupacks.

### DETAILLIERTE BESCHREIBUNG DER AUSFÜHRUNGSBEISPIELE

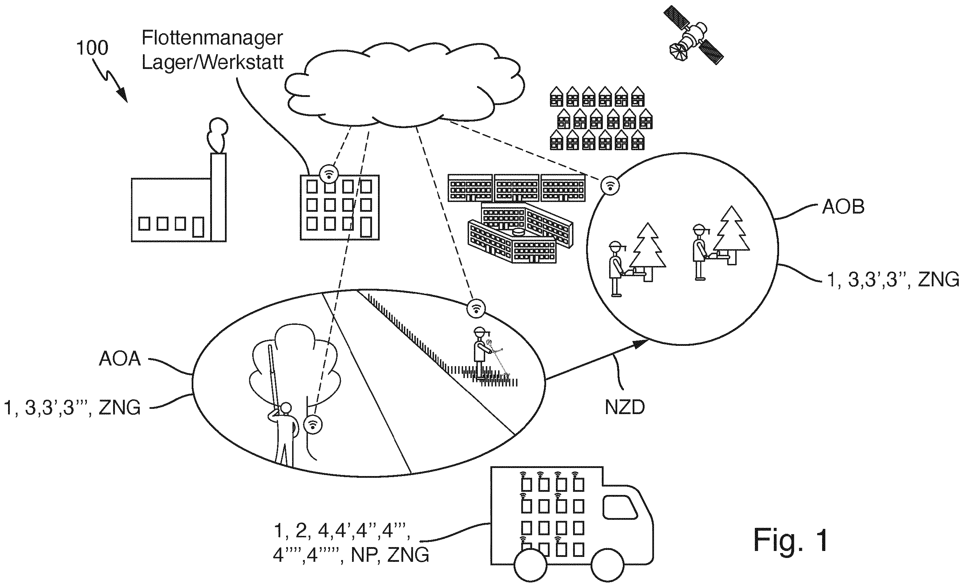

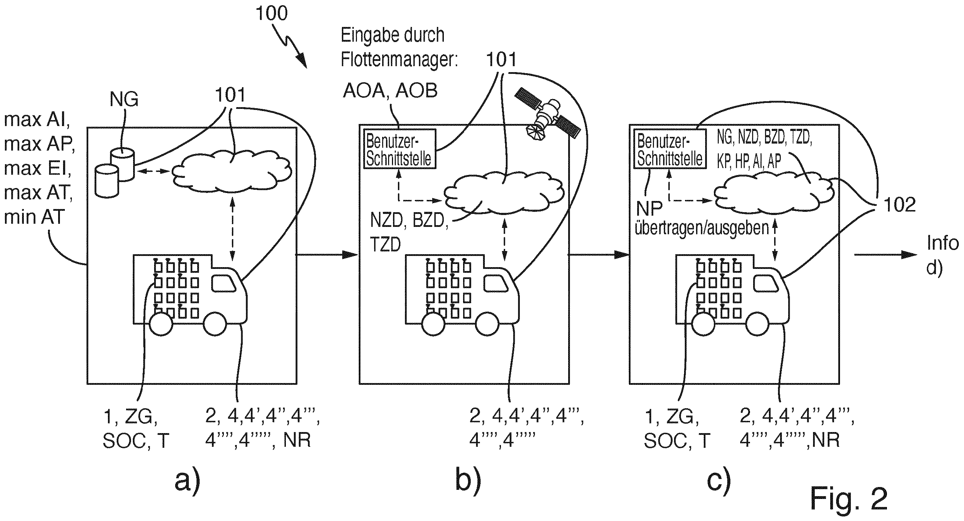

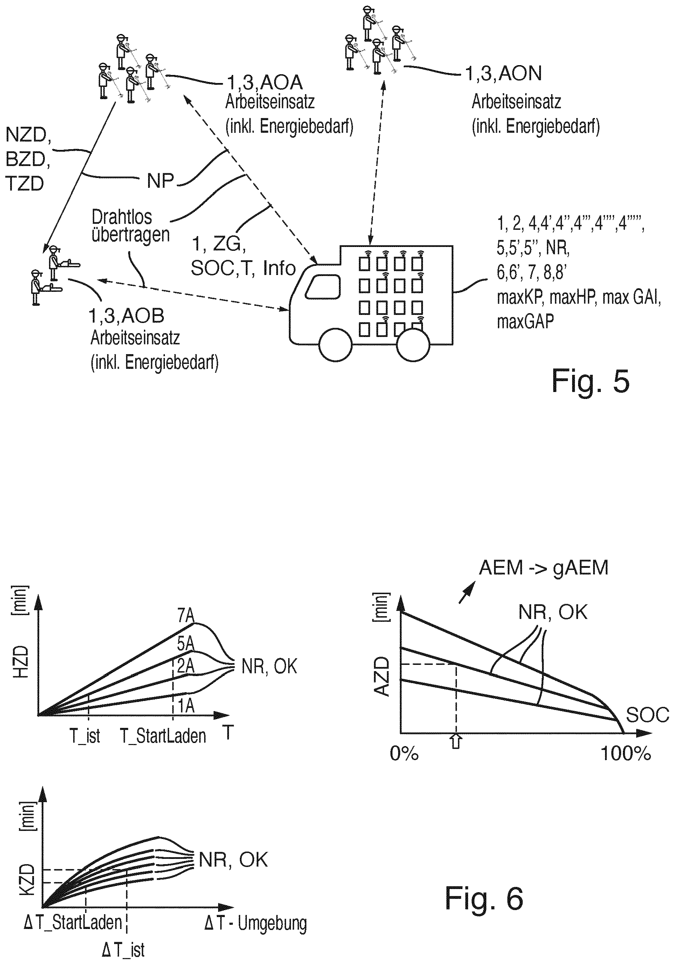

Fig. 1 bis 6 zeigen ein erfindungsgemäßes System 100 und ein erfindungsgemäßes Verfahren zum Bestimmen mindestens eines Nutzungsparameters NP für mindestens einen Akkupack 1 zum Nutzen einer Ladegeräteinrichtung 2 zum Aufladen von benutzeraustauschbaren Akkupacks 1 zum Antrieb mindestens eines mobilen Geräts 3. Ein Transportmittel 4 weist die Ladegeräteinrichtung 3 auf.

Das System 100 weist auf: eine Ermittlungseinrichtung 101 und eine Bestimmungseinrichtung 102. Die Ermittlungseinrichtung 101 ist ausgebildet: zum Ermitteln von Zustands- und Nenngrößen ZNG der Akkupacks 1 betreffend ein mögliches Aufladen der Akkupacks 1 mittels der Ladegeräteinrichtung 2, und zum Ermitteln von möglichen Nutzungszeitdauern NZD der Akkupacks 1 zum möglichen Nutzen der Ladegeräteinrichtung 2 betreffend ein mögliches Aufladen der Akkupacks 1 mittels der Ladegeräteinrichtung 2, insbesondere ermittelt. Die Bestimmungseinrichtung 102 ist ausgebildet: zum Bestimmen des mindestens einen Nutzungsparameters NP für mindestens einen der Akkupacks 1 zum Nutzen der Ladegeräteinrichtung 2 zum Aufladen des mindestens einen Akkupacks 1 mittels der Ladegeräteinrichtung 2 durch Verknüpfen der ermittelten Zustands- und Nenngrößen ZNG und der ermittelten möglichen Nutzungszeitdauern NZD unter Berücksichtigung mindestens einer Nutzungsgrenze NR der Ladegeräteinrichtung 2, insbesondere bestimmt.

Das Verfahren weist die Schritte auf: a) Ermitteln von den Zustands- und Nenngrößen ZNG der Akkupacks 1 betreffend das mögliche Aufladen der Akkupacks 1 mittels der Ladegeräteinrichtung 2, insbesondere mittels der Ermittlungseinrichtung 101. b) Ermitteln von den möglichen Nutzungszeitdauern NZD der Akkupacks 1 zu dem möglichen Nutzen der Ladegeräteinrichtung 2 betreffend das mögliche Aufladen der Akkupacks 1 mittels der Ladegeräteinrichtung 2, insbesondere mittels der Ermittlungseinrichtung 101. c) Bestimmen des mindestens einen Nutzungsparameters NP für den mindestens einen der Akkupacks 1 zu dem Nutzen der Ladegeräteinrichtung 2 zu dem Aufladen des mindestens einen Akkupacks 1 mittels der Ladegeräteinrichtung 2 durch Verknüpfen der ermittelten Zustands- und Nenngrößen ZNG und der ermittelten möglichen Nutzungszeitdauern NZD unter Berücksichtigung der mindestens einen Nutzungsgrenze NR der Ladegeräteinrichtung 2, insbesondere mittels der Bestimmungseinrichtung 102.

Im Detail weist das System 100 auf: die Akkupacks 1, die Ladegeräteinrichtung 2, das mindestens eine mobile Gerät 3 und/oder das Transportmittel 4.

Des Weiteren weist die mindestens eine Nenngröße NG auf, insbesondere ist, und/oder ist korrespondierend: ein maximaler Auflade- und/oder Antriebsstrom maxAl, insbesondere von minimal 200 mA, insbesondere minimal 1 A, und/oder maximal 1000 A, insbesondere maximal 200 A, und/oder eine maximale elektrische Auflade- und/oder Antriebsleistung maxAP, insbesondere von minimal 200 W, insbesondere minimal 1 kW, und/oder maximal 10 kW, insbesondere maximal 5 kW, und/oder ein maximaler elektrischer Energieinhalt maxEI, insbesondere von minimal 1 Wh und/oder maximal 8 kWh, insbesondere 4 kWh, und/oder eine maximale Auflade- und/oder Antriebstemperatur maxAT, insbesondere 120 °C, und/oder eine minimale Auflade- und/oder Antriebstemperatur minAT, insbesondere - 20 °C.

Zusätzlich oder alternativ sind die Akkupacks 1, insbesondere jeweils, zu dem Antrieb mit einer Nennspannung von minimal 9 V (Volt), insbesondere minimal 18V, und/oder maximal 100 V, insbesondere maximal 72 V, insbesondere 36 V, ausgebildet.

Außerdem sind die Akkupacks 1 zum Antrieb mobiler Geräte 3.

Zusätzlich oder alternativ ist das mindestens eine mobile Gerät 3 boden- und/oder handgeführt, insbesondere handgetragen, und/oder ein Garten-, Forst-, Bau- und/oder Bodenbearbeitungsgerät 3', insbesondere eine Säge 3", oder ein Hoch-Entaster 3‴, oder eine Heckenschere, oder ein Heckenschneider, oder ein Gehölzschneider, oder eine Astschere, ein Trennschleifer, oder ein Blasgerät, oder ein Laubbläser, oder ein Sauggerät, oder ein Laubsauger, oder ein Reinigungsgerät, oder ein Hochdruckreiniger, oder ein Kehrgerät, oder eine Kehrwalze, oder eine Kehrbürste, oder ein Rasenmäher, oder eine Grasschere, oder ein Freischneider, oder ein Vertikutierer.

Weiter ist das Transportmittel 4 ein Fahrzeug 4', insbesondere ein Landfahrzeug 4", insbesondere ein Straßenfahrzeug 4‴, insbesondere ein Kraftfahrzeug 4"", insbesondere ein Automobil 4ʺ‴, oder ein Zweirad, insbesondere ein Motorrad, oder ein Anhänger.

Zudem weist die mindestens eine Nutzungsgrenze NR auf, insbesondere ist, und/oder ist korrespondierend: ein, insbesondere variabler, maximaler Gesamtaufladestrom maxGAI und/oder eine, insbesondere variable, maximale elektrische Gesamtaufladeleistung maxGAP zum Aufladen des mindestens einen Akkupacks 1, und/oder eine, insbesondere variable, maximale Kühlleistung maxKP zum Kühlen des mindestens einen Akkupacks 1 und/oder eine, insbesondere variable, maximale Heizleistung maxHP zum Heizen des mindestens einen Akkupacks 1, und/oder eine maximale Anzahl, insbesondere Mehrzahl, von Leistungsabgabeschnittstellen 5, insbesondere Akkupackaufnahmen 5', insbesondere Akkupackschächten 5", insbesondere für den mindestens einen Akkupack 1.

Des Weiteren weist das Transportmittel 4 mindestens eine, insbesondere direkte, Strahlungsenergie-Umwandlungs-Einrichtung 6, insbesondere eine Solarzelle 6`, und/oder mindestens eine Brennstoffzelle 7 und/oder mindestens einen, insbesondere elektrischen, Energiespeicher 8, insbesondere eine Batterie 8', zur Versorgung der Ladegeräteinrichtung 2 mit elektrischer Leistung auf, insbesondere versorgt.

Außerdem weist die mindestens eine Zustandsgröße ZG auf, insbesondere ist, und/oder ist korrespondierend: ein Ladezustand SOC, und/oder eine Temperatur T.

Weiter weist der Schritt c) auf: Bestimmen von Kühlzeitdauern KZD zum Kühlen und/oder Heizzeitdauern HZD zum Heizen der Akkupacks 1 basierend auf der mindestens einen ermittelten maximalen Aufladetemperatur maxAT und/oder der mindestens einen ermittelten minimalen Aufladetemperatur minAT sowie der ermittelten Temperaturen T, insbesondere unter Berücksichtigung der maximalen Kühlleistung maxKP und/oder der maximalen Heizleistung maxHP, insbesondere mittels der Bestimmungseinrichtung 102. Bestimmen von möglichen Aufladezeitdauern AZD zum Aufladen der Akkupacks 1 basierend auf den bestimmten Kühlzeitdauern KZD und/oder den bestimmten Heizzeitdauern HZD sowie den ermittelten möglichen Nutzungszeitdauern NZD, insbesondere mittels der Bestimmungseinrichtung 102. Bestimmen von möglichen elektrischen Aufladeenergiemengen AEM der Akkupacks 1 basierend auf den bestimmten möglichen Aufladezeitdauern AZD sowie dem mindestens einen ermittelten maximalen Aufladestrom maxAl und/oder der mindestens einen ermittelten maximalen Aufladeleistung maxAP, insbesondere und dem mindestens einen ermittelten maximalen elektrischen Energieinhalt maxEI und/oder den ermittelten Ladezuständen SOC und/oder unter Berücksichtigung des maximalen Gesamtaufladestroms maxGAI und/oder der maximalen elektrischen Gesamtaufladeleistung maxGAP, insbesondere mittels der Bestimmungseinrichtung 102. Bestimmen des mindestens einen Nutzungsparameters NP basierend auf den bestimmten möglichen Aufladeenergiemengen AEM, insbesondere beginnend mit der größten Aufladeenergiemenge gAEM und/oder unter Berücksichtigung der maximalen Anzahl von Leistungsabgabeschnittstellen 5, insbesondere mittels der Bestimmungseinrichtung 102.

Zudem weist der Schritt c) auf: Bestimmen des mindestens einen Nutzungsparameters NP anhand eines Optimierungskriteriums OK. Das Optimierungskriterium OK ist eine, insbesondere die, größte Aufladeenergiemenge gAEM des mindestens einen Akkupacks 1.

Des Weiteren weist der mindestens eine Nutzungsparameter NP auf, insbesondere ist, und/oder ist korrespondierend: den mindestens einen Akkupack 1 zum Nutzen der Ladegeräteinrichtung 2, und/oder mindestens eine Kühlleistung KP zum Kühlen und/oder mindestens eine Heizleistung HP zum Heizen des mindestens einen Akkupacks 1, und/oder mindestens einen Aufladestrom AI und/oder mindestens eine elektrische Aufladeleistung AP zum Aufladen des mindestens einen Akkupacks 1.

Außerdem weist das Verfahren den Schritt auf: d) Ausgeben einer benutzerwahrnehmbaren Information Info über den mindestens einen bestimmten Nutzungsparameter NP, insbesondere den mindestens einen Akkupack 1 zum Nutzen der Ladegeräteinrichtung 2, insbesondere mittels des mindestens einen Akkupacks 1, der Ladegeräteinrichtung 2, des Transportmittels 4 und/oder einer Benutzer-Schnittstelle des Systems 100, insbesondere in Form eines Smartphones und/oder eines Tablets.

Weiter weist der Schritt a) auf: drahtloses Übertragen der mindestens einen Zustandsgröße ZG, insbesondere von mindestens einem der Akkupacks 1, insbesondere nicht nutzend die Ladegeräteinrichtung 2.

Zudem weist mindestens eine der möglichen Nutzungszeitdauern NZD auf, insbesondere ist, und/oder ist korrespondierend: eine mögliche Aufenthaltszeitdauer BZD mindestens eines der Akkupacks 1 an Bord des Transportmittels 4, insbesondere eine mögliche Transportzeitdauer TZD des Transportmittels 4, insbesondere von einem Ausgangsort AOA, zu einem möglichen Antriebsort AOB mindestens eines der Akkupacks 1.

In dem gezeigten Ausführungsbeispiel weist das System 100 minimal neun Akkupacks 1 und/oder maximal hundert Akkupacks 1 auf, insbesondere entsprechend, insbesondere gleichend, einer zum Antrieb bzw. zur Abgabe an die mobilen Geräte 3 verfügbaren Energie von minimal 15 kWh und/oder maximal 50 kWh. Zusätzlich oder alternativ weist die Ladegeräteinrichtung 2 nur eine einzige Leistungsabgabeschnittstelle 5 oder mindestens zwei, insbesondere mindestens fünf, insbesondere mindestens zehn, insbesondere mindestens zwanzig, insbesondere mindestens fünfzig, Leistungsabgabeschnittstellen 5 auf.

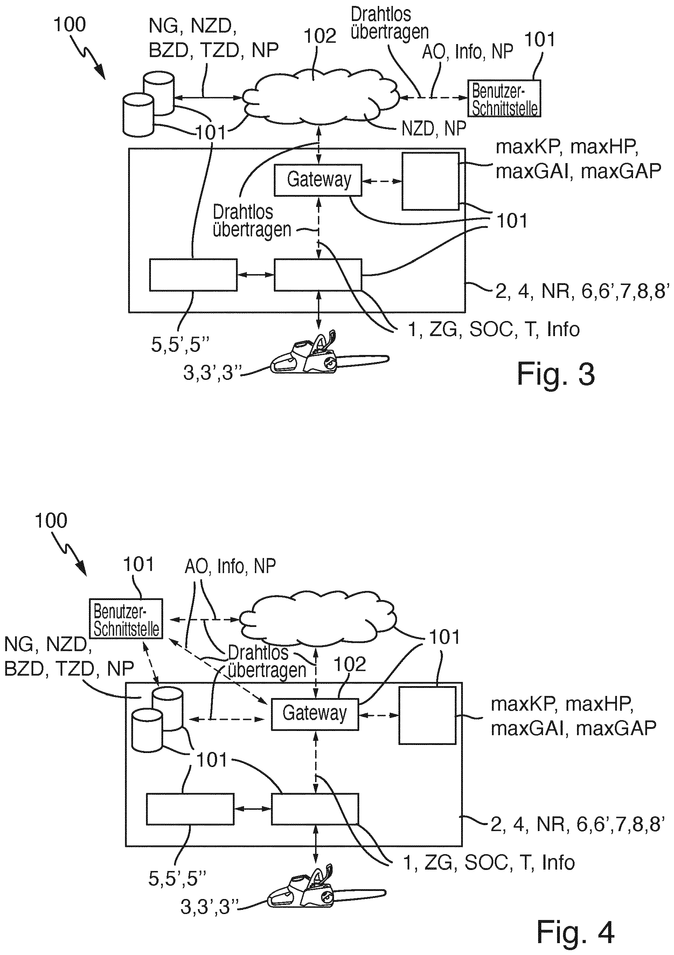

In Fig. 3 wird das Bestimmen des mindestens einen Nutzungsparameters NP remote von dem Transportmittel 4 ausgeführt. In Fig. 4 wird das Bestimmen des mindestens einen Nutzungsparameters NP lokal in dem Transportmittel 4 ausgeführt, insbesondere wobei eine Cloud-Anbindung z.B. für eine Routenplanung und/oder für eine Verkehrsinformation sein kann.

In einem Ausführungsbeispiel kann die Ladegeräteinrichtung 2 nur eine einzige Leistungsabgabeschnittstelle 5 aufweisen, aber zwei Akkupacks 1 mit verschiedenen Zustands- und Nenngrößen ZNG können aufzuladen sein. Insbesondere kann eine Temperatur T eines der Akkupacks 1 über der maximalen Auflade- und Antriebstemperatur maxAT sein, so dass der eine Akkupack 1 zeitlich vor dem möglichen Aufladen gekühlt werden bräuchte. Eine Temperatur T eines anderen der Akkupacks 1 kann unter der maximalen Auflade- und Antriebstemperatur maxAT und über der minimalen Auflade- und/oder Antriebstemperatur minAT sein, so dass der andere Akkupack 1 direkt aufgeladen werden könnte. Aber eine maximale elektrische Auflade- und/oder Antriebsleistung maxAP des einen Akkupacks 1 kann über einer maximalen elektrischen Auflade- und/oder Antriebsleistung maxAP des anderen Akkupacks 1 sein. Im Übrigen können mögliche Nutzungszeitdauern NZD der zwei Akkupacks 1 gleich sein. Durch Verknüpfen der ermittelten Zustands- und Nenngrößen ZNG und der ermittelten möglichen Nutzungszeitdauern NZD kann unter Berücksichtigung, insbesondere nur, der mindestens einen, insbesondere einzigen, Nutzungsgrenze NR in Form der einzigen Leistungsabgabeschnittstelle 5 anhand des Optimierungskriteriums OK, insbesondere nur, der mindestens eine, insbesondere einzige, Nutzungsparameter NP als, insbesondere nur, der eine Akkupack 1 in einem Fall von langen möglichen Nutzungszeitdauern NZD und der andere Akkupack 1 in einem anderen Fall von kurzen möglichen Nutzungszeitdauern NZD bestimmt werden. Dies ermöglicht die größte Aufladeenergiemenge gAEM, insbesondere nur, des einen Akkupacks 1 in dem einen Fall und des anderen Akkupacks 1 in dem anderen Fall.

In einem weiteren Ausführungsbeispiel können die zwei Akkupacks 1 mit den verschiedenen Zustands- und Nenngrößen ZNG aufzuladen sein und die Ladegeräteinrichtung 2 kann mindestens zwei Leistungsabgabeschnittstellen 5 aufweisen. Durch Verknüpfen der ermittelten Zustands- und Nenngrößen ZNG und der ermittelten möglichen Nutzungszeitdauern NZD kann unter Berücksichtigung der Nutzungsgrenzen NR in Form einer maximalen elektrischen Gesamtaufladeleistung maxGAP und einer maximalen Kühlleistung maxKP anhand des Optimierungskriteriums OK der mindestens eine Nutzungsparameter NP als eine Kühlleistung KP zum Kühlen und eine elektrische Aufladeleistung AP zum Aufladen des einen Akkupacks 1, insbesondere und eine andere elektrische Aufladeleistung AP zum, insbesondere gleichzeitigen, Aufladen des anderen Akkupacks 1, in einem Fall von langen möglichen Nutzungszeitdauern NZD und, insbesondere nur, als eine, insbesondere einzige, elektrische Aufladeleistung AP zum Aufladen, insbesondere nur, des anderen Akkupacks 1 in einem anderen Fall von kurzen möglichen Nutzungszeitdauern NZD bestimmt werden. Dies ermöglicht die größte Aufladeenergiemenge gAEM des einen Akkupacks 1, insbesondere und des anderen Akkupacks 1, in dem einen Fall und des anderen Akkupacks 1 in dem anderen Fall.

Wie die gezeigten und vorhergehend erläuterten Ausführungsbeispiele deutlich machen, stellt die Erfindung ein vorteilhaftes Verfahren und ein vorteilhaftes System, insbesondere jeweils, zum Bestimmen mindestens eines Nutzungsparameters für mindestens einen Akkupack zum Nutzen einer Ladegeräteinrichtung zum Aufladen von benutzeraustauschbaren Akkupacks zum Antrieb mindestens eines mobilen Geräts, wobei ein Transportmittel die Ladegeräteinrichtung aufweist, bereit, insbesondere wobei das Verfahren und das System, insbesondere jeweils, verbesserte Eigenschaften aufweisen.

## Patentansprüche

1. Verfahren zum Bestimmen mindestens eines Nutzungsparameters (NP) für mindestens einen Akkupack (1) zum Nutzen einer Ladegeräteinrichtung (2) zum Aufladen von benutzeraustauschbaren Akkupacks (1) zum Antrieb mindestens eines mobilen Geräts (3), wobei ein Transportmittel (4) die Ladegeräteinrichtung (2) aufweist, wobei das Verfahren die Schritte aufweist:
a) Ermitteln von Zustands- und Nenngrößen (ZNG) der Akkupacks (1) betreffend ein mögliches Aufladen der Akkupacks (1) mittels der Ladegeräteinrichtung (2),
b) Ermitteln von möglichen Nutzungszeitdauern (NZD) der Akkupacks (1) zum möglichen Nutzen der Ladegeräteinrichtung (2) betreffend ein mögliches Aufladen der Akkupacks (1) mittels der Ladegeräteinrichtung (2), und
c) Bestimmen des mindestens einen Nutzungsparameters (NP) für mindestens einen der Akkupacks (1) zum Nutzen der Ladegeräteinrichtung (2) zum Aufladen des mindestens einen Akkupacks (1) mittels der Ladegeräteinrichtung (2) durch Verknüpfen der ermittelten Zustands- und Nenngrößen (ZNG) und der ermittelten möglichen Nutzungszeitdauern (NZD) unter Berücksichtigung mindestens einer Nutzungsgrenze (NR) der Ladegeräteinrichtung (2).

2. Verfahren nach dem vorhergehenden Anspruch,
- wobei die mindestens eine Nenngröße (NG) aufweist, insbesondere ist, und/oder korrespondierend ist:
- ein maximaler Auflade- und/oder Antriebsstrom (maxAl), insbesondere von minimal 200 mA, insbesondere minimal 1 A, und/oder maximal 1000 A, insbesondere maximal 200 A, und/oder eine maximale elektrische Auflade- und/oder Antriebsleistung (maxAP), insbesondere von minimal 200 W, insbesondere minimal 1 kW, und/oder maximal 10 kW, insbesondere maximal 5 kW, und/oder ein maximaler elektrischer Energieinhalt (maxEI), insbesondere von minimal 1 Wh und/oder maximal 8 kWh, insbesondere 4 kWh, und/oder
- eine maximale Auflade- und/oder Antriebstemperatur (maxAT), insbesondere 120 °C, und/oder eine minimale Auflade- und/oder Antriebstemperatur (minAT), insbesondere - 20 °C.

3. Verfahren nach einem der vorhergehenden Ansprüche,
- wobei die Akkupacks (1) zum Antrieb mobiler Geräte (3) sind, und/oder
- wobei das mindestens eine mobile Gerät (3) boden- und/oder handgeführt, insbesondere handgetragen, und/oder ein Garten-, Forst-, Bau- und/oder Bodenbearbeitungsgerät (3') ist, insbesondere eine Säge (3"), oder ein Hoch-Entaster (3‴), oder eine Heckenschere, oder ein Heckenschneider, oder ein Gehölzschneider, oder eine Astschere, ein Trennschleifer, oder ein Blasgerät, oder ein Laubbläser, oder ein Sauggerät, oder ein Laubsauger, oder ein Reinigungsgerät, oder ein Hochdruckreiniger, oder ein Kehrgerät, oder eine Kehrwalze, oder eine Kehrbürste, oder ein Rasenmäher, oder eine Grasschere, oder ein Freischneider, oder ein Vertikutierer.

4. Verfahren nach einem der vorhergehenden Ansprüche,
- wobei das Transportmittel (4) ein Fahrzeug (4'), insbesondere ein Landfahrzeug (4"), insbesondere ein Straßenfahrzeug (4‴), insbesondere ein Kraftfahrzeug (4ʺʺ), insbesondere ein Automobil (4ʺ‴), oder ein Zweirad, insbesondere ein Motorrad, oder ein Anhänger, ist.

5. Verfahren nach einem der vorhergehenden Ansprüche,
- wobei die mindestens eine Nutzungsgrenze (NR) aufweist, insbesondere ist, und/oder korrespondierend ist:
- ein, insbesondere variabler, maximaler Gesamtaufladestrom (maxGAI) und/oder eine, insbesondere variable, maximale elektrische Gesamtaufladeleistung (maxGAP) zum Aufladen des mindestens einen Akkupacks (1), und/oder
- eine, insbesondere variable, maximale Kühlleistung (maxKP) zum Kühlen des mindestens einen Akkupacks (1) und/oder eine, insbesondere variable, maximale Heizleistung (maxHP) zum Heizen des mindestens einen Akkupacks (1), und/oder
- eine maximale Anzahl, insbesondere Mehrzahl, von Leistungsabgabeschnittstellen (5), insbesondere Akkupackaufnahmen (5'), insbesondere Akkupackschächten (5").

6. Verfahren nach einem der vorhergehenden Ansprüche,
- wobei das Transportmittel (4) mindestens eine, insbesondere direkte, Strahlungsenergie-Umwandlungs-Einrichtung (6), insbesondere eine Solarzelle (6'), und/oder mindestens eine Brennstoffzelle (7) und/oder mindestens einen, insbesondere elektrischen, Energiespeicher (8), insbesondere eine Batterie (8'), zur Versorgung der Ladegeräteinrichtung (2) mit elektrischer Leistung aufweist.

7. Verfahren nach einem der vorhergehenden Ansprüche,
- wobei die mindestens eine Zustandsgröße (ZG) aufweist, insbesondere ist, und/oder korrespondierend ist:
- ein Ladezustand (SOC), und/oder
- eine Temperatur (T).

8. Verfahren nach den Ansprüchen 2 und 7, und insbesondere 5,
- wobei der Schritt c) aufweist:
- Bestimmen von Kühlzeitdauern (KZD) zum Kühlen und/oder Heizzeitdauern (HZD) zum Heizen der Akkupacks (1) basierend auf der mindestens einen ermittelten maximalen Aufladetemperatur (maxAT) und/oder der mindestens einen ermittelten minimalen Aufladetemperatur (minAT) sowie der ermittelten Temperaturen (T), insbesondere unter Berücksichtigung der maximalen Kühlleistung (maxKP) und/oder der maximalen Heizleistung (maxHP),
Bestimmen von möglichen Aufladezeitdauern (AZD) zum Aufladen der Akkupacks (1) basierend auf den bestimmten Kühlzeitdauern (KZD) und/oder den bestimmten Heizzeitdauern (HZD) sowie den ermittelten möglichen Nutzungszeitdauern (NZD),
- Bestimmen von möglichen elektrischen Aufladeenergiemengen (AEM) der Akkupacks (1) basierend auf den bestimmten möglichen Aufladezeitdauern (AZD) sowie dem mindestens einen ermittelten maximalen Aufladestrom (maxAl) und/oder der mindestens einen ermittelten maximalen Aufladeleistung (maxAl), insbesondere und dem mindestens einen ermittelten maximalen elektrischen Energieinhalt (maxEI) und/oder den ermittelten Ladezuständen (SOC) und/oder unter Berücksichtigung des maximalen Gesamtaufladestroms (maxGAI) und/oder der maximalen elektrischen Gesamtaufladeleistung (maxGAP), und
- Bestimmen des mindestens einen Nutzungsparameters (NP) basierend auf den bestimmten möglichen Aufladeenergiemengen (AEM), insbesondere beginnend mit der größten Aufladeenergiemenge (gAEM) und/oder unter Berücksichtigung der maximalen Anzahl von Leistungsabgabeschnittstellen (5).

9. Verfahren nach einem der vorhergehenden Ansprüche,
- wobei der Schritt c) aufweist: Bestimmen des mindestens einen Nutzungsparameters (NP) anhand eines Optimierungskriteriums (AK), wobei das Optimierungskriterium (OK) eine größte Aufladeenergiemenge (gAEM) des mindestens einen Akkupacks (1) ist.

10. Verfahren nach einem der vorhergehenden Ansprüche, insbesondere Anspruch 5,
- wobei der mindestens eine Nutzungsparameter (NP) aufweist, insbesondere ist, und/oder korrespondierend ist:
- den mindestens einen Akkupack (1) zum Nutzen der Ladegeräteinrichtung (2), und/oder
- mindestens eine Kühlleistung (KP) zum Kühlen und/oder mindestens eine Heizleistung (HP) zum Heizen des mindestens einen Akkupacks (1), und/oder
- mindestens einen Aufladestrom (AI) und/oder mindestens eine elektrische Aufladeleistung (AP) zum Aufladen des mindestens einen Akkupacks (1).

11. Verfahren nach einem der vorhergehenden Ansprüche, wobei das Verfahren den Schritt aufweist:
d) Ausgeben einer benutzerwahrnehmbaren Information (Info) über den mindestens einen bestimmten Nutzungsparameter (NP), insbesondere den mindestens einen Akkupack (1) zum Nutzen der Ladegeräteinrichtung (2).

12. Verfahren nach einem der vorhergehenden Ansprüche,
- wobei der Schritt a) aufweist: drahtloses Übertragen der mindestens einen Zustandsgröße (ZG), insbesondere von mindestens einem der Akkupacks (1), insbesondere nicht nutzend die Ladegeräteinrichtung (2).

13. Verfahren nach einem der vorhergehenden Ansprüche,
- wobei mindestens eine der möglichen Nutzungszeitdauern (NZD) aufweist, insbesondere ist, und/oder korrespondierend ist:
- eine mögliche Aufenthaltszeitdauer (BZD) mindestens eines der Akkupacks (1) an Bord des Transportmittels (4),
- insbesondere eine mögliche Transportzeitdauer (TZD) des Transportmittels (4) zu einem möglichen Antriebsort (AOB) mindestens eines der Akkupacks (1).

14. System (100) zum Bestimmen mindestens eines Nutzungsparameters (NP) für mindestens einen Akkupack (1) zum Nutzen einer Ladegeräteinrichtung (2) zum Aufladen von benutzeraustauschbaren Akkupacks (1) zum Antrieb mindestens eines mobilen Geräts (3), wobei ein Transportmittel (4) die Ladegeräteinrichtung (2) aufweist, insbesondere zum Ausführen eines Verfahrens nach einem der vorhergehenden Ansprüche, wobei das System (100) aufweist:
- eine Ermittlungseinrichtung (101), wobei die Ermittlungseinrichtung (101) ausgebildet ist:
- zum Ermitteln von Zustands- und Nenngrößen (ZNG) der Akkupacks (1) betreffend ein mögliches Aufladen der Akkupacks (1) mittels der Ladegeräteinrichtung (2), und
- zum Ermitteln von möglichen Nutzungszeitdauern (NZD) der Akkupacks (1) zum möglichen Nutzen der Ladegeräteinrichtung (2) betreffend ein mögliches Aufladen der Akkupacks (1) mittels der Ladegeräteinrichtung (2), und
- eine Bestimmungseinrichtung (102), wobei die Bestimmungseinrichtung (102) ausgebildet ist:
- zum Bestimmen des mindestens einen Nutzungsparameters (NP) für mindestens einen der Akkupacks (1) zum Nutzen der Ladegeräteinrichtung (2) zum Aufladen des mindestens einen Akkupacks (1) mittels der Ladegeräteinrichtung (2) durch Verknüpfen der ermittelten Zustands- und Nenngrößen (ZNG) und der ermittelten möglichen Nutzungszeitdauern (NZD) unter Berücksichtigung mindestens einer Nutzungsgrenze (NR) der Ladegeräteinrichtung (2).

15. System (100) nach dem vorhergehenden Anspruch, wobei das System (100) aufweist:
- die Akkupacks (1), die Ladegeräteinrichtung (2), das mindestens eine mobile Gerät (3) und/oder das Transportmittel (4).
